# EUROPEAN PATENT APPLICATION

(11) **EP 4 451 310 A1**
(43) Date of publication of application: **23.10.2024**
(21) Application number: 24170735.5
(22) Date of filing: 17.04.2024
(51) Int. Cl.: H01J 37/32

(54) **SUBSTRATE PROCESSING APPARATUS**

(30) Priority: 18.04.2023 KR 20230050729
(71) Applicant: PSK Inc., Hwaseong-si, Gyeonggi-do 18849 (KR)
(72) Inventor: LEE, Jong Chan, 18849 Hwaseong-si (KR); YOO, Kwang Sung, 18849 Hwaseong-si (KR); CHU, Hyen Woo, 18849 Hwaseong-si (KR)
(74) Representative: Dragotti & Associati S.R.L.

(57) **Abstract**

A substrate processing apparatus includes a housing defining a processing space, a lower electrode unit supporting the substrate, an upper electrode unit spaced apart from the lower electrode unit with the substrate therebetween, a gas supply unit configured to supply a process gas for plasma processing an edge region of the substrate, and a protective layer arranged on a surface of at least a portion of the lower electrode unit and the upper electrode unit and including a material having great plasma resistance.

## Description

### CROSS-REFERENCE TO RELATED APPLICATION

This application is based on and claims priority under 35 U.S.C. §119 to Korean Patent Application No. 10-2023-0050729, filed on April 18, 2023, in the Korean Intellectual Property Office, the disclosure of which is incorporated by reference herein in its entirety.

### BACKGROUND

### 1. Field

The disclosure relates to a substrate processing apparatus, and more particularly, to a substrate processing apparatus for processing a substrate by using plasma.

### 2. Description of the Related Art

Plasma refers to an ionized gaseous state including ions, radicals, electrons, and the like. Plasma may be generated by excessively high temperatures, strong electric fields, or radio frequency (RF) electromagnetic fields. Semiconductor device manufacturing processes may include etching processes of removing thin films from substrates by using plasma. Such etching processes may be performed when ions and radical particles contained in the plasma collide or react with the thin films on the substrates.

Apparatuses for processing substrates by using plasma may supply process gases to processing spaces and excite the process gases to generate plasma. The plasma may collide not only with the substrates but also with components within housings. Components or the like included in substrate processing apparatuses may collide with the plasma and be etched.

### SUMMARY

Provided is a substrate processing apparatus capable of reducing damage to components caused by reaction with plasma.

Provided is a substrate processing apparatus capable of increasing a life span.

Provided is a substrate processing apparatus capable of providing uniform process performance with respect to a substrate.

Problems to be solved by the disclosure are not limited to the above-described problems, and problems not mentioned may be clearly understood by one of ordinary skill in the art from the description and accompanying drawings.

Additional aspects will be set forth in part in the description which follows and, in part, will be apparent from the description, or may be learned by practice of the presented embodiments of the disclosure.

According to an aspect of the disclosure, a substrate processing apparatus includes a housing defining a processing space, a lower electrode unit arranged in the processing space and supporting the substrate, an upper electrode unit spaced apart from the lower electrode unit with the substrate therebetween, a gas supply unit configured to supply a process gas for plasma processing an edge region of the substrate, and a protective layer arranged on a surface of at least a portion of the lower electrode unit and the upper electrode unit and including a material having greater plasma resistance than each of the lower electrode unit and the upper electrode unit.

The protective layer may include a material including at least two of Nd, Pm, Sm, Gd, Y, Sc, Er, F, and O.

The protective layer may include a material including at least three of Nd, Pm, Sm, Gd, Y, Sc, Er, F, and O.

The protective layer may include at least one of YF₃ and Y₂O₃ as a matrix and include at least one of Nd, Pm, Sm, Gd, Sc, and Er as a dopant.

A thickness of the protective layer may be 50 µm to 150 µm.

The upper electrode unit may include a dielectric plate arranged to overlap a portion of the substrate in a thickness direction of the substrate, and the protective layer may include a first protective layer arranged on a lower surface of the dielectric plate.

A thickness of the first protective layer may be non-uniform.

The lower surface of the dielectric plate may be stepped.

The lower surface of the dielectric plate may include a first lower surface spaced apart from the substrate by a first gap, a second lower surface spaced apart from the substrate by a second gap greater than the first gap, and a boundary surface connecting the first lower surface to the second lower surface and having a first round surface convex toward the processing space.

The first round surface may be in contact with the first lower surface from among the boundary surface.

The first protective layer may include a first sub-protective layer arranged on the first lower surface, a second sub-protective layer arranged on the second lower surface, and a third sub-protective layer arranged on the boundary surface.

A thickness of the second sub-protective layer may be greater than a thickness of the first sub-protective layer.

A thickness of the third sub-protective layer may decreases from the second sub-protective layer to the first sub-protective layer.

The third sub-protective layer may have a second round surface convex toward the processing space.

A radius of curvature of the second round surface may be greater than or equal to a radius of curvature of the first round surface.

The radius of curvature of the second round surface may be 10 mm or less.

A gap between the substrate and the first sub-protective layer may be adjusted according to the radius of curvature of the second round surface.

The gap between the substrate and the first sub-protective layer may be adjusted to be inversely proportional to the radius of curvature of the second round surface.

The substrate processing apparatus may include an optical sensor arranged on the housing and configured to acquire the radius of curvature of the second round surface by using light.

The optical sensor may include a light irradiator configured to irradiate the light toward the second round surface, and a photodetector configured to detect light, which travels through the processing space without being blocked by the second round surface, from among the light.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a view schematically illustrating substrate processing equipment according to an embodiment;
FIG. 2 is a view illustrating an embodiment of a substrate processing apparatus provided in a process chamber of FIG. 1;
FIG. 3 is a block diagram illustrating a controller according to an embodiment;
FIG. 4 is a view illustrating an example in which the substrate processing apparatus of FIG. 2 performs a plasma processing process;
FIG. 5 illustrates an experimental result showing a degree of particle generation over time in a dielectric plate not coated with a protective layer and a dielectric plate coated with a protective layer, according to an embodiment;
FIG. 6 is a view illustrating a substrate processing apparatus including a stepped dielectric plate, according to an embodiment;
FIG. 7 is a view illustrating a substrate processing apparatus including a first protective layer having a non-uniform thickness, according to an embodiment;
FIG. 8A is a view illustrating a substrate processing apparatus including an optical sensor, according to an embodiment;
FIG. 8B is a view schematically illustrating a relationship between a second round surface and an optical sensor; and
FIG. 9 is a flowchart illustrating a method of adjusting a gap between a first sub-protective layer and a substrate according to a second radius of curvature, according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments will be described in detail with reference to the accompanying drawings. In the following drawings, the same reference numerals refer to the same components, and the size of each component in the drawings may be exaggerated for clarity and convenience of description. Meanwhile, embodiments described below are merely illustrative, and various modifications may be made from the embodiments.

Hereinafter, when a component is referred to as being "above" or "on" another component, the component may be directly above or below the other component, or on the left or right of the other component by contact and may be above or below the other component, or on the left or right of the other component without contact. The singular forms are intended to include the plural forms as well, unless the context clearly indicates otherwise. When a portion is intended to "include" a component, this may mean that the component may further include other components rather than excluding the other components unless otherwise stated.

The use of the term "the" and indicative terms similar thereto may correspond to both the singular and plural forms. Unless the order of operations constituting a method is clearly stated or stated to the contrary, the operations may be performed in any appropriate order and are not limited to the order described.

The terms "... er", "module", etc. described herein may refer to units that process at least one function or operation and may be implemented as hardware, software, or as a combination of hardware and software.

Connections or connecting units of lines between components illustrated in the drawings illustrate functional connections and/or physical or circuit connections and may be represented in actual apparatuses as alternative or additional various functional connections, physical connections, or circuit connections.

The expression such as "at least one" that precedes a list of elements does not limit the entire list of elements and does not limit individual elements of the list. For example, the expressions such as "at least one of A, B, and C" or "at least one selected from a group consisting of A, B, and C" may be interpreted as A alone, B alone, C alone, or a combination of two or more of A, B, and C, such as ABC, AB, BC, and AC.

When "about" or "substantially" is used in connection with a numerical value, the numerical value involved may be interpreted to include a manufacturing or operating deviation (e.g., ±10 %) around a predefined numerical value. Alternatively, when the terms "generally" and "substantially" are used in relation to geometric shapes, it may be intended that geometric precision is not needed and tolerance for the shapes is within the scope of the present embodiment. Regardless of whether a numerical value or a shape is limited to "about" or "substantially," the values and shape may be interpreted to include a manufacturing or operating deviation (e.g., ±10 %) around the predefined numerical value.

Although the terms, 'first', 'second', etc. may be used herein to describe various elements, these elements should not be limited by these terms. These terms are only used to distinguish one element from another.

The use of all examples or illustrative terms is simply intended to describe the technical spirit in detail, and the scope thereof is not limited by these examples or illustrative terms unless limited by the claims.

Hereinafter, embodiments are described in detail with reference to the accompanying drawings.

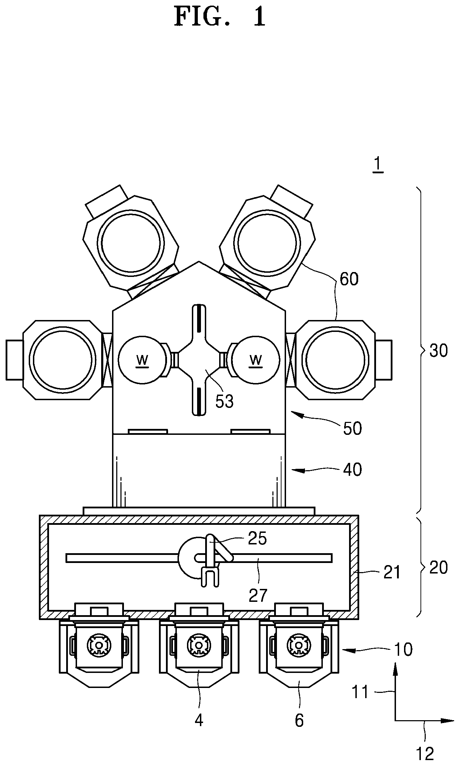

FIG. 1 is a view schematically illustrating substrate processing equipment according to an embodiment. Referring to FIG. 1, substrate processing equipment 1 may include an equipment front end module (EFEM) 20 and a processing module 30. The EFEM 20 and the processing module 30 may be arranged in one direction.

The EFEM 20 may include a load port 10 and a transfer frame 21. The load port 10 may be arranged in front of the EFEM 20 in a first direction 11. The load port 10 may include a plurality of support portions 6. The plurality of support portions 6 may be arranged in a row in a second direction 12, and carriers 4 (e.g., a cassette, a front opening unified pod (FOUP), or the like), which accommodate a substrate W to be provided for a process and a substrate W on which the process is completed may be seated on the support portions 6. The carriers 4 may accommodate the substrate W to be provided for the process and the substrate W on which the process is completed.

The transfer frame 21 may be arranged between the load port 10 and the processing module 30. The transfer frame 21 may include a first transfer robot 25 for transferring the substrate W between the load port 10 and the processing module 30. The first transfer robot 25 may transfer the substrate W between the carrier 4 and the processing module 30 by moving along a transfer rail 27 provided in the second direction 12.

The processing module 30 may include a load lock chamber 40, a transfer chamber 50, and a process chamber 60. The processing module 30 may process the substrate W by receiving the substrate W returned from the EFEM 20.

The load lock chamber 40 may be arranged adjacent to the transfer frame 21. As an example, the load lock chamber 40 may be arranged between the transfer chamber 50 and the EFEM 20. The load lock chamber 40 may provide a space in which the substrate W waits before the substrate W to be provided for the process is transferred to the process chamber 60 or before the substrate W on which the process is completed is transferred to the EFEM 20.

The transfer chamber 50 may transfer the substrate W. The transfer chamber 50 may be arranged adjacent to the load lock chamber 40. The transfer chamber 50 may have a polygonal body when viewed from above. Referring to FIG. 1, the transfer chamber 50 may have a pentagonal body when viewed from above. The load lock chamber 40 and a plurality of process chambers 60 may be arranged along a circumference of the body on an outer surface of the body. Passages (not shown) through which the substrates W enter and exit may be formed in respective sidewalls of the body, and the passages may connect the transfer chamber 50 to the load lock chamber 40 or the process chambers 60. Each passage may be provided with a door (not shown) for opening and closing the passage to seal the inside thereof.

A second transfer robot 53, which transfers the substrate W between the load lock chamber 40 and the process chambers 60, may be arranged in an inner space of the transfer chamber 50. The second transfer robot 53 may transfer the unprocessed substrate W waiting in the load lock chamber 40 to the process chamber 60, or transfer the processed substrate W to the load lock chamber 40. Alternatively, the second transfer robot 53 may carry the substrate W into a processing space 102 of a housing 100 described below or take the substrate W out of the processing space 102.

Alternatively, the second transfer robot 53 may transfer the substrate W between the process chambers 60 to sequentially provide the substrate W to the plurality of process chambers 60. As illustrated in FIG. 1, when the transfer chamber 50 has a pentagonal body, the load lock chamber 40 may be arranged on a sidewall of the transfer chamber 50 adjacent to the EFEM 20, and the process chambers 60 may be consecutively arranged on the remaining sidewalls of the transfer chamber 50. The transfer chamber 50 may be provided in various shapes according to a needed process module, in addition to the above shapes.

The process chambers 60 may be arranged adjacent to the transfer chamber 50. The process chambers 60 may be arranged along a circumference of the transfer chamber 50. A plurality of process chambers 60 may be provided. In each process chamber 60, process processing may be performed on the substrate W. The process chamber 60 may receive the substrate W transferred from the second transfer robot 53, perform process processing on the substrate W, and provide the second transfer robot 53 with the substrate W on which process processing is completed. Process processing performed in each process chamber 60 may be different from each other.

Hereinafter, a substrate processing apparatus 1000 for performing a plasma process in the process chamber 60 is described. The substrate processing apparatus 1000 is described as an example of being configured to perform a plasma processing process on an edge region of the substrate W in the process chamber 60. However, the substrate processing apparatus 1000 is not limited thereto and may be equally or similarly applied to various chambers in which processing on the substrate W is performed. The substrate processing apparatus 1000 may be equally or similarly applied to various chambers in which a plasma processing process on the substrate W is performed.

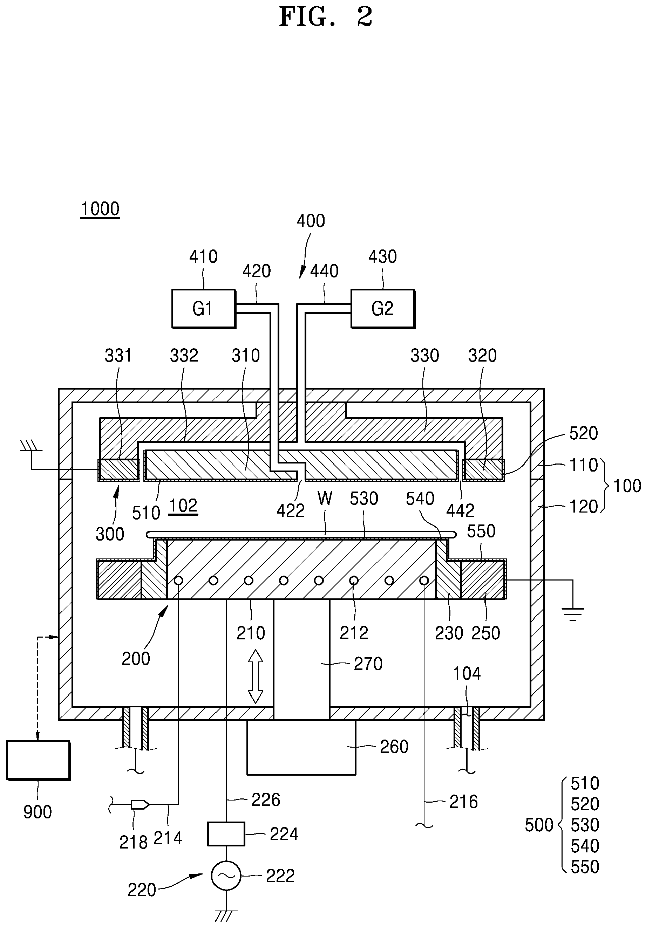

FIG. 2 is a view illustrating an embodiment of a substrate processing apparatus 1000 provided in a process chamber of FIG. 1. Referring to FIG. 2, the substrate processing apparatus 1000 provided in the process chamber 60 may perform a certain process on a substrate W by using plasma. For example, the substrate processing apparatus 1000 may etch or ash a film material on the substrate W.

The film material may be various types of film materials such as a polysilicon film, a silicon oxide film, and a silicon nitride film. Alternatively, the film material may be a natural oxide film or a chemically generated oxide film. The film material may be a byproduct generated in a process of processing the substrate W. The film material may be an impurity that adheres and/or remains on the substrate W.

The substrate processing apparatus 1000 may perform a plasma process on the substrate W. For example, the substrate processing apparatus 1000 may process the substrate W by supplying a process gas and generating plasma from the supplied process gas. The substrate processing apparatus 1000 may process an edge region of the substrate W by suppling a process gas and generate plasma from the supplied process gas. Hereinafter, the substrate processing apparatus 1000 is described as an example of being a bevel etch apparatus that performs etching processing on the edge region of the substrate W.

The substrate processing apparatus 1000 may include a housing 100, a lower electrode unit 200, an upper electrode unit 300, and a gas supply unit 400.

The housing 100 may define a processing space 102. The housing 100 may include an upper housing 110 (or a first housing) and a lower housing 120 (or a second housing). The upper housing 110 and the lower housing 120 may be combined with each other to define the processing space 102. In addition, the upper housing 110 may be rotatably coupled to the lower housing 120 by a rotational coupler (not shown). For example, the upper housing 110 and the lower housing 120 may be coupled to each other by the rotational coupler (not shown) that may be a hinge mechanism.

The upper housing 110 may be at an open location or at a closed location. Hereinafter, a location of the upper housing 110 at which the upper housing 110 is combined with the lower housing 120 to define the processing space 102 may be referred to as the closed location, and a location of the upper housing 110, which exposes the processing space 102 to the outside, may be defined as the open location.

In addition, the atmosphere of the processing space 102 may be isolated from the outside when the upper housing 110 is at the closed position, and the processing space 102 isolated from the outside may be adjusted to a low pressure state (e.g., a vacuum pressure atmosphere) close to vacuum while the substrate W is processed. In addition, the housing 100 may include a material including metal. In addition, an inner surface of the housing 100 may be coated with an insulating material. In addition, the housing 100 may be grounded.

Also, the housing 100 may be a vacuum chamber. For example, an exhaust hole 104 may be formed in a bottom surface of the housing 100. Plasma generated in the processing space 102 or gases G1 and G2 supplied to the processing space 102 may be exhausted to the outside through the exhaust hole 104. In addition, by-products, which are generated in the process of processing the substrate W by using the plasma, may be exhausted to the outside through the exhaust hole 104. Also, the exhaust hole 104 may be connected to an exhaust line (not shown). The exhaust line may be connected to a decompressor that provides decompression. The decompressor may provide decompression to the processing space 102 through the exhaust line.

The lower electrode unit 200 may support the substrate W in the processing space 102. The lower electrode unit 200 may include a chuck 210. The chuck 210 may support the substrate W in the processing space 102. The chuck 210 may have a support surface supporting the substrate W. The chuck 210 may have a circular shape when viewed from above. The chuck 210 may have a smaller diameter than the substrate W when viewed from above. Accordingly, a central region of the substrate W, which is supported by the chuck 210, may be seated on the support surface of the chuck 210, and an edge region of the substrate W may not be in contact with the support surface of the chuck 210.

A heating unit (not shown) may be provided inside the chuck 210. The heating unit (not shown) may heat the chuck 210. The heating unit may be a heater. Alternatively, a cooling passage 212 may be formed in the chuck 210. The cooling passage 212 may be formed inside the chuck 210. A cooling fluid supply line 214 and a cooling fluid discharge line 216 may be connected to the cooling passage 212. The cooling fluid supply line 214 may be connected to a cooling fluid supply source 218. The cooling fluid supply source 218 may store a cooling fluid and/or supply the cooling fluid to the cooling fluid supply line 214. Alternatively, the cooling fluid supplied to the cooling passage 212 may be discharged to the outside through the cooling fluid discharge line 216.

The cooling fluid, which is stored in and/or supplied by the cooling fluid supply source 218, may be cooling water or a cooling gas. Alternatively, a shape of the cooling passage 212, which is formed in the chuck 210, is not limited to the shape illustrated in FIG. 2 and may be variously modified. Alternatively, the component for cooling the chuck 210 is not limited to the component for supplying the cooling fluid, but may be provided as various components (e.g., a cooling plate, and the like) capable of cooling the chuck 210.

The lower electrode unit 200 may further include a power source unit 220. The power source unit 220 may supply radio frequency (RF) power to the chuck 210. The power source unit 220 may include a power source 222, a matcher 224, and a power source line 226. The power source 222 may be a bias power source. Alternatively, the power source 222 may be an RF power source. The power source 222 may be connected to the chuck 210 via the power source line 226. Alternatively, the matcher 224 may be provided to the power line 226 to perform impedance matching.

The lower electrode unit 210 may further include an insulating ring 230. The insulating ring 230 may be provided to have a ring shape when viewed from above. The insulating ring 230 may be configured to surround the chuck 210 when viewed above.

For example, the insulating ring 230 may have a ring shape. The insulating ring 230 may include an insulating material. The insulating ring 230 may electrically isolate a lower edge electrode 250 described below from the chuck 210. The chuck 210 may include a material including metal. The insulating ring 230 may include an insulating material such as ceramic.

In addition, an upper surface of the insulating ring 230 may have a stepped shape. A height of an inner upper surface adjacent to the central region of the substrate W from among the upper surface of the insulating ring 230 may be higher than a height of an outer upper surface far from the central region of the substrate W from among the upper surface of the insulating ring 230. An inflow of plasma described below may be relatively smooth in a region above the outer upper surface of the insulating ring 230, an inflow of the plasma may be blocked or suppressed in a region above the inner upper surface of the insulating ring 230, and thus, processing efficiency for the edge region of the substrate W may further increase.

The lower electrode unit 210 may further include the lower edge electrode 250. The lower edge electrode 250 may be configured to surround the insulating ring 230 when viewed from above. The lower edge electrode 250 may have a ring shape when viewed from above. The lower edge electrode 250 may be grounded. When viewed from above, the lower edge electrode 250 may be arranged at a location capable of generating plasma in the edge region of the substrate W supported by the chuck 210. For example, the edge region of the substrate W may overlap the lower edge electrode 250 in a thickness direction of the substrate W.

The lower electrode unit 210 may further include an actuator 260 and a shaft 270. The actuator 260 and the shaft 270 may be combined with each other to lift and lower the chuck 210. The shaft 270 may be coupled to the chuck 210. The shaft 270 may be connected to the actuator 260. The actuator 260 may lift and lower the chuck 210 via the shaft 270 in a vertical direction. When the actuator 260 lifts and lowers the chuck 210, a gap between an upper surface of the substrate W supported by the chuck 210 and a first protective layer 510 arranged on the upper electrode unit 300 described below may be adjusted.

The upper electrode unit 300 may be provided to face the lower electrode unit 200. The upper electrode unit 300 may be provided to face the upper surface of the substrate W supported by the lower electrode unit 200.

The upper electrode unit 300 may include a dielectric plate 310. The dielectric plate 310 may be arranged to face the upper surface of the substrate W supported by the chuck 210 in the processing space 102. The dielectric plate 310 may be arranged above the lower electrode unit 200. The dielectric plate 310 may include a material including ceramic.

A flow path, which is connected to a first gas supply unit 410 of the gas supply unit 400 described below, may be formed in the dielectric plate 310. A first gas discharge end 422 may be configured such that the first gas G1 supplied by the first gas supply unit 410 is supplied to the central region of the substrate W supported by the lower electrode unit 200. Alternatively, the first gas discharge end 422 may be configured such that the first gas G1 is supplied to an upper surface of the central region of the substrate W supported by a support body 330.

The upper electrode unit 300 may further include an upper edge electrode 320. The upper edge electrode 320 may be arranged to face the lower edge electrode 250. The upper edge electrode 320 may have a ring shape when viewed from above. The upper edge electrode 320 may be a counter electrode facing the lower edge electrode 250.

The upper edge electrode 320 may be provided to surround the dielectric plate 310 when viewed from above. The upper edge electrode 320 may have a ring shape when viewed from above. The upper edge electrode 320 may be provided to be spaced apart from the dielectric plate 310 when viewed from above. An inner circumference of the upper edge electrode 320 and an outer circumference of the dielectric plate 310 may be combined with each other to define a second gas discharge end 442 for supplying a process gas to the edge region of the substrate W.

The upper electrode unit 300 may further include the support body 330. The support body 330 may support the dielectric plate 310 and the upper edge electrode 320. The support body 330 may fix the dielectric plate 310 and the upper edge electrode 320 to the housing 100. The support body 330 may include a material including metal. The support body 330 may be grounded. The support body 330 may be electrically connected to the housing 100 to be grounded. The support body 330 may be combined with the dielectric plate 310 to form a gas channel.

The support body 330 may include an edge lower surface 331 and a middle lower surface 332. The edge lower surface 331 may be adjacent to the edge region of the substrate W viewed from above, and the middle lower surface 332 may be adjacent to the central region of the substrate W. The middle lower surface 332 may be formed to be recessed in a lower surface of the support body 330 in an upward direction. The edge lower surface 331 may generally have a ring shape when viewed from above. The upper edge electrode 320 may be provided on the edge lower surface 331.

The middle lower surface 332 of the support body 330 and the dielectric plate 310 may be combined with each other to define a gas channel. The gas channel may function as a gas flow path through which a process gas supplied from the second gas supply unit 430 flows toward the edge region of the substrate W. The gas channel may be in fluid communication with the second gas discharge end 442 described below. The gas channel may be in fluid communication with the processing space 102.

A protective layer 500 may be arranged on a surface of at least one of the lower electrode unit 200 and the upper electrode unit 300. The protective layer 500 may prevent the lower electrode unit 200 and the upper electrode unit 300 from being damaged by plasma. When at least one of the lower electrode unit 200 and the upper electrode unit 300 is damaged and deformed by plasma or impurities such as particles are generated, a process for the substrate W may be affected, and the impurities may adhere to the substrate W to increase a defect rate of the substrate W.

The protective layer 500 may include a different material from the lower electrode unit 200 and the upper electrode unit 300. The protective layer 500 may include a material having greater plasma resistance than the lower electrode unit 200 and the upper electrode unit 300. Here, the plasma resistance may refer to corrosion resistance or erosion resistance.

The protective layer 500 may include a material including at least two of Nd, Pm, Sm, Gd, Y, Sc, Er, F, Al, and O. Alternatively, the protective layer 500 may include a material including at least three of Nd, Pm, Sm, Gd, Y, Sc, Er, F, and O. Alternatively, the protective layer 500 may include at least one of YF₃ and Y₂O₃ as a matrix and may include at least one of Nd, Pm, Sm, Gd, Sc, and Er as a dopant. When more material components are included in the protective layer 500, the plasma resistance may increase by reducing a probability of plasma reaction to a particular material. When more material components are included in the protective layer 500, generation of impurities by plasma may be reduced by increasing sinterability of the protective layer 500.

The protective layer 500 may be coated by an atmosphere plasma spray (APS) method. However, the protective layer 500 is not limited thereto and may be coated by using an aerosol method, a cold spray method, an oxalic acid method, or the like.

As shown in FIG. 2, the protective layer 500 may be arranged on an upper surface and a side surface of the lower electrode unit 200, and a lower surface and a side surface of the upper electrode unit 300. For example, the protective layer 500 may include a first protective layer 510 arranged on a lower surface and a side surface of the dielectric plate 310, a second protective layer 520 arranged on a lower surface and a side surface of the upper edge electrode 320, a third protective layer 530 arranged on an upper surface of the chuck 210, a fourth protective layer 540 arranged on an upper surface of the insulating ring 230, and a fifth protective layer 550 arranged on an upper surface and a side surface of the lower edge electrode 250. However, the protective layer 500 is not limited thereto and may be arranged at the center of a region in which plasma is concentrated. For example, the protective layer 500 may not include the third protective layer 530 arranged on the upper surface of the chuck 210 of the lower electrode unit 200. Accordingly, when the substrate W is seated on the chuck 210, the plasma is less likely to flow onto the upper surface of the chuck 210. Therefore, the third protective layer 530 may not be formed on the upper surface of the chuck 210. Alternatively, the protective layer 500 may not be arranged on the side surface of the dielectric plate 310 of the upper electrode unit 300. However, a probability may be low that the second gas G2 flows out between the dielectric plate 310 and the upper edge electrode 320 and plasma flows in.

The protective layer 500 arranged on the lower electrode unit 200 and the upper electrode unit 300 may include the same material. However, the disclosure is not limited thereto. For example, protective layers (e.g., the first and fourth protective layers 510 and 540), which include a material including at least one of Y₂O₃ and YF₃ as a matrix and including at least one of Nd, Pm, Sm, Gd, Sc, and Er as a dopant, may be arranged on the dielectric plate 310 and the insulating ring 230. Protective layers (e.g., the second and fifth protective layers 520 and 550), which include a material including Al₂O₃ as a matrix and at least one of Nd, Pm, Sm, Gd, Sc, and Er as a dopant, may be arranged on the lower edge electrode 250 and the upper edge electrode 320. When the lower edge electrode 250 and the upper edge electrode 320 include metal, the first and fifth protective layers 510 and 550 may also include metal to improve adhesion between the lower edge electrode 250 and the upper edge electrode 320.

When the substrate processing apparatus 1000 operates and the number of processes increases, the protective layer 500 may also be damaged even when a damage rate is slow. When a thickness of the protective layer 500 is too small, a re-coating period of the protective layer 500 may be shortened. Therefore, the protective layer 500 needs to secure the re-coating period longer than a certain period. The thickness of the protective layer 500 according to an embodiment may be about 50 µm or more.

Meanwhile, the protective layer 500 may be arranged on the lower surface of the upper edge electrode 320 and the upper surface of the lower edge electrode 250. When the thickness of the protective layer 500 is too great, formation of an electric field by the upper edge electrode 320 and the lower edge electrode 250 may be inhibited. Accordingly, the thickness of the protective layer 500 may be about 150 µm or less. For example, the thickness of the protective layer 510 may be about 50 µm to about 150 µm or about 80 µm to about 120 µm.

The gas supply unit 400 may supply a gas to the processing space 102. The gas supply unit 400 may supply the first gas G1 and the second gas G2 to the processing space 102. The gas supply unit 400 may include a first gas supply unit 410, a first gas supply line 420, a second gas supply unit 430, and a second gas supply line 440.

The first gas supply unit 410 may supply the first gas G1 to the processing space 102. The first gas G1 may be an inert gas such as nitrogen or argon. The first gas supply unit 410 may supply the first gas G1 to the central region of the substrate W supported by the chuck 210. The first gas supply unit 410 may supply the first gas G1 to the first gas supply line 420. The first gas supply line 420 may have one end connected to the first gas supply unit 410 and the other end in fluid communication with the first gas discharge end 422 formed in a central region of the dielectric plate 310. The first gas G1 supplied by the first gas supply unit 410 may be supplied to the central region of the substrate W through the first gas supply line 420. The first gas G1 supplied by the first gas supply unit 410 may be supplied to a space between the dielectric plate 310 and the substrate W through the first gas supply line 420.

The second gas supply unit 430 may supply the second gas G2 to the processing space 102. The second gas G2 may be a process gas excited in a plasma state. The second gas G2 may be a process gas in which a plurality of gases of different types are mixed with one another. For example, the second gas supply unit 430 may be configured to supply the second gas G2 including at least two of O₂, N₂, Ar, SF₆, and CF₄. The second gas supply unit 430 may supply the second gas G2 to the second gas supply line 440. The second gas supply line 440 may have one end connected to the second gas supply unit 430 and the other end in fluid communication with the second gas discharge end 442. The second gas G2, which is a mixture gas supplied by the second gas supply unit 430, may be supplied to the edge region of the substrate W through the second gas supply line 440.

The substrate processing apparatus 1000 according to an embodiment may further include a controller 900. The controller 900 may control the substrate processing apparatus 1000 to perform a plasma processing process. For example, the controller 900 may control the gas supply unit 400, the actuator 260, and the like. In detail, the controller 900 may control the gas supply unit 400 so that the power source 222 applies power to the chuck 210 and generates plasma in the edge region of the substrate W supported by the chuck 210 when the first gas supply unit 410 and/or the second gas supply unit 430 supply gases.

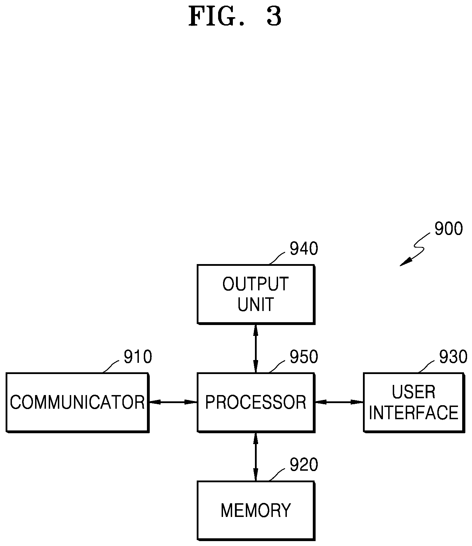

FIG. 3 is a block diagram illustrating the controller 900 according to an embodiment. Referring to FIG. 3, the controller 900 may include a communicator 910 that communicates with the components of the substrate processing apparatus 1000, e.g., the first gas supply unit 410, the second gas supply unit 430, the actuator 260, and the like, a memory 920 that stores a control program executed by the substrate processing apparatus 100, various types of data, a processing recipe, and the like, a user interface 930 that receives a user command of a designer, a worker, or the like using the substrate processing apparatus 1000, an output unit 940 that outputs information regarding a processing process and/or a current state, and the like of the substrate processing apparatus 1000, and a processor 950 that executes overall control of the substrate processing apparatus 1000.

The communicator 910 may be a wired communication module or a wireless communication module. The user interface 930 may be a keyboard, a button, a touch pad, or the like, and the memory 920 may be a hard disk, a flexible disk such as CD-ROM or DVD, flash memory, or the like. The output unit 940 may be a display, a speaker, a light source, or the like.

The controller 900 may control one substrate processing apparatus 1000 or may control a plurality of substrate processing apparatuses 1000. Alternatively, the controller 900 may overall control not only the substrate processing apparatus 1000 but also the substrate processing equipment 1 shown in FIG. 1.

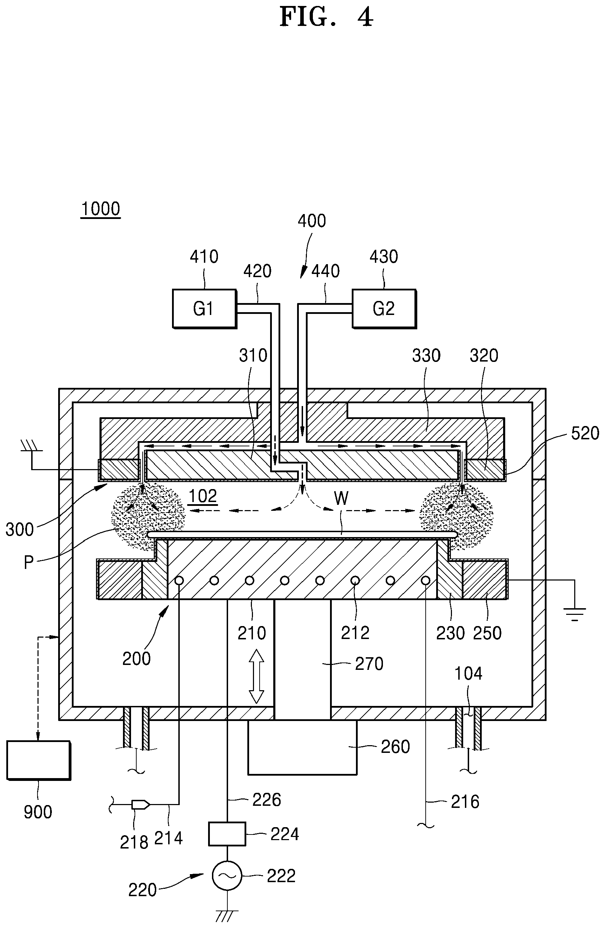

FIG. 4 is a view illustrating an example in which the substrate processing apparatus 1000 of FIG. 2 performs a plasma processing process. Referring to FIG. 4, the substrate processing apparatus 1000 according to an embodiment may generate plasma in an edge region of a substrate W to process the edge region of the substrate W. When the substrate processing apparatus 1000 processes the edge region of the substrate W, a first gas supply unit 410 may supply a first gas G1 to a central region of the substrate W, and a second gas supply unit 430 may supply a second gas G2 to the edge region of the substrate W. The second gas G2 supplied by the second gas supply unit 430 may be a process gas, and thus may be excited in a plasma state P to process the edge region of the substrate W. For example, a thin film on the edge region of the substrate W may be etched by the plasma P.

In addition, the first gas G1 supplied to the central region of the substrate W may be an inert gas, and the first gas G1 may prevent the second gas G2 from flowing onto the central region of the substrate W to further increase processing efficiency for the edge region of the substrate W. A shaft 270 may move a chuck 210 upwards to reduce a gap between the substrate W and a first protective layer 510, so that a bevel etch process may be performed on the substrate W.

The plasma P generated in the substrate processing apparatus 1000 may etch not only the edge region of the substrate W but also a lower electrode unit 200 and an upper electrode unit 300. In the substrate processing apparatus 1000 according to an embodiment, a protective layer 500, which includes a material having high plasma resistance, may be arranged on a surface of at least a portion of the lower electrode unit 200 and the upper electrode unit 300. Therefore, the lower electrode unit 200 and the upper electrode unit 300 may be prevented from being damaged, and a processing yield of the substrate W may increase.

The protective layer 500 may include a material including at least two of Nd, Pm, Sm, Gd, Y, Sc, Er, F, and O. Alternatively, the protective layer 500 may include a material including at least three of Nd, Pm, Sm, Gd, Y, Sc, Er, F, and O. Alternatively, the protective layer 500 may include at least one of YF₃ and Y₂O₃ as a matrix and may include at least one of Nd, Pm, Sm, Gd, Sc, and Er as a dopant.

Alternatively, protective layers (e.g., 510 and 540), which are arranged on a dielectric plate 310 and an insulating ring 230, may include at least one of YF₃ and Y₂O₃ as a matrix and include at least one of Nd, Pm, Sm, Gd, Sc, and Er as a dopant, and protective layers (e.g., 520 and 550), which are arranged on a lower edge electrode 250 and an upper edge electrode 320, may include Al₂O₃ as a matrix and include at least one of Nd, Pm, Sm, Gd, Sc, and Er as a dopant.

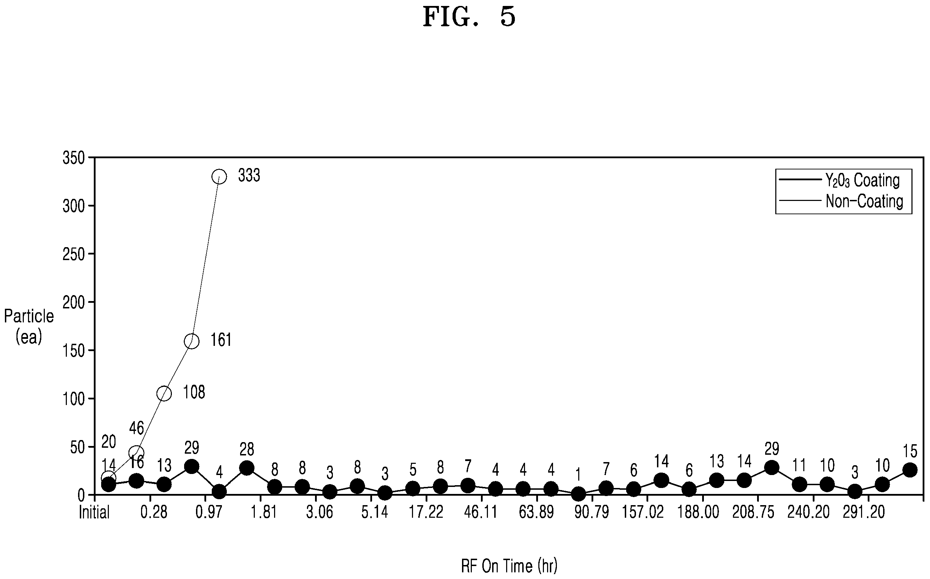

FIG. 5 illustrates an experimental result showing a degree of particle generation over time in a dielectric plate not coated with a protective layer and a dielectric plate coated with a protective layer, according to an embodiment. Yttria (Y₂O) may be coated as a protective layer on a surface of the dielectric plate 310 formed of alumina (Al₂O₃).

As shown in FIG. 5, in a dielectric plate not coated with a protective layer, particles may rapidly increase after a time 0.3 of RF-on time. However, in the dielectric plate coated with a protective layer including yttria, even when the RF-on time increases, the particles may not increase rapidly.

A substrate processing apparatus according to an embodiment may include a space in a certain range near an edge region of the substrate W to activate plasma.

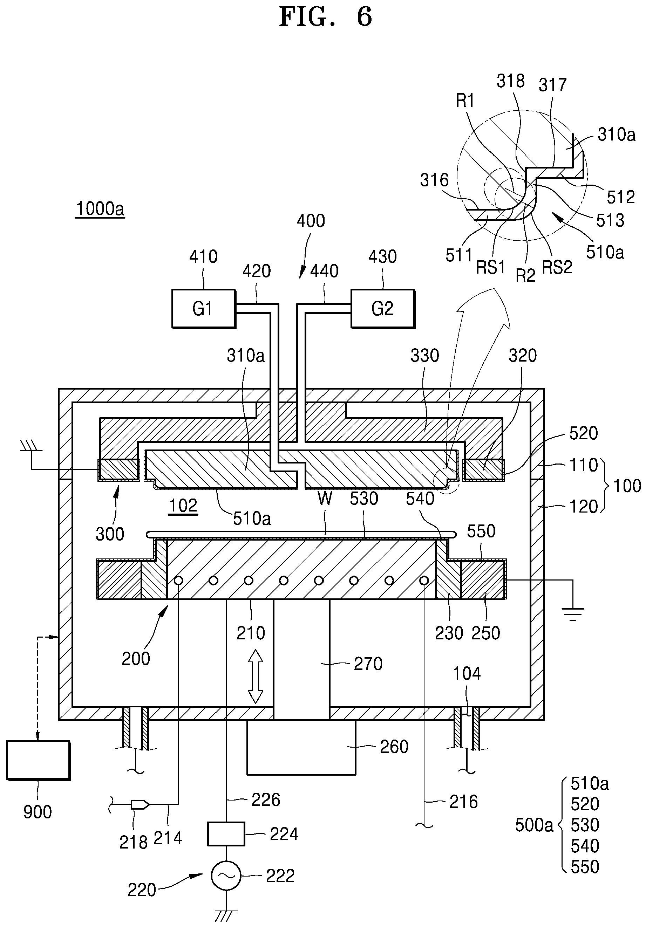

FIG. 6 is a view illustrating a substrate processing apparatus 1000a including a stepped dielectric plate 310, according to an embodiment. For brevity of description, the description of FIG. 6, which is substantially the same as the description of FIG. 2, is omitted.

A dielectric plate 310a may include a lower surface having a stepped shape. For example, the lower surface of the dielectric plate 310a may include a first lower surface 316 and a second lower surface 317. The first lower surface 316 may be a lower surface adjacent to a central region of a substrate W when viewed from above. The second lower surface 317 may be a lower surface surrounding the first lower surface 316 when viewed from above. The second lower surface 317 may be a lower surface adjacent to an edge region of the substrate W when viewed from above.

A gap between the first lower surface 316 and the substrate W and a gap between the second lower surface 317 and the substrate W may be different from each other. For example, the gap between the first lower surface 316 and the substrate W may be smaller than the gap between the second lower surface 317 and the substrate W. An inflow of plasma may be relatively smooth in a region below the second lower surface 317 of the stepped dielectric plate 310a, an inflow of the plasma may be relatively suppressed in a region below the first lower surface 316, and thus, processing efficiency for the edge region of the substrate W may be improved.

A boundary surface 318 having a round surface convex toward a processing space 102 may be arranged between the first lower surface 316 and the second lower surface 317. The round surface may be a non-flat surface and may have a shape convex toward the processing space 102. The round surface may have a radius of curvature. Here, the radius of curvature may be an average radius of curvature of the round surface. However, the radius of curvature is not limited thereto and may be the smallest value or the greatest value from among the radiuses of curvature of the round surface. The radius of curvature may be defined by a designer, a worker, or the like of a substrate processing apparatus 1000.

The radius of curvature may be about 10 mm or less. For example, the radius of curvature may be about 1 mm to about 7 mm. For convenience of description, the round surface included in the boundary surface 318 may be referred to as a first round surface RS1, and a radius of curvature of the first round surface RS1 may be referred to as a first radius of curvature R1.

A first protective layer 510a may be arranged on a surface of the dielectric plate 310a. The first protective layer 510a is as described with reference to FIG. 1, and a detailed description thereof is omitted. For example, the first protective layer 510a may include a first sub-protective layer 511 arranged on the first lower surface 316, a second sub-protective layer 512 arranged on the second lower surface 317, and a third sub-protective layer 513 arranged on the boundary surface 318.

The first protective layer 510 may be formed along the lower surface of the dielectric plate 310a, and thus, the first protective layer 510 may also have a round surface convex toward the processing space 102. The entire surface of the third sub-protective layer 513 may be a round surface. However, the substrate processing apparatus 1000 is not limited thereto and only a portion of the surface of the third sub-protective layer 513 may be a round surface. For example, from among the surface of the third sub-protective layer 513, a surface adjacent to the first sub-protective layer 511 may be a round surface. For convenience of description, the round surface included in the first protective layer 510 may be referred to as a second round surface RS2. A radius of curvature of the second round surface RS2 may be referred to as a second radius of curvature R2.

The second radius of curvature R2 may be the same as the first radius of curvature R1. However, the disclosure is not limited thereto. The second radius of curvature R2 may be different from the first radius of curvature R1. For example, the second radius of curvature R2 may be greater than or equal to the first radius of curvature R1. The third sub-protective layer 513 may include the second round surface RS2, and thus, a chipping effect on plasma may be more effectively reduced.

In contrast, when the second radius of curvature R2 increases, the plasma colliding with the second round surface RS2 may enter the central region of the substrate W and etch the central region of the substrate W. Accordingly, etching processing may performed up to a region of the substrate W on which the etching processing is not desired, and thus, a defect rate of the substrate W may increase. Therefore, the second radius of curvature R2 may be limited to a range that reduces defects of the substrate W. The second radius of curvature R2 may be about 10 mm or less. For example, the second radius of curvature R2 may be about 1 mm to about 7 mm.

Meanwhile, even when a protective layer 500a is coated, the protective layer 500a may be also damaged when a plasma processing process is performed, and thus, a thickness of the protective layer 500a may decrease. In the substrate processing apparatus 1000 according to an embodiment, a thickness of a region of the protective layer 500a that is in contact with a large amount of plasma may be different from a thickness of a region of the protective layer 500a that is in contact with a small amount of plasma.

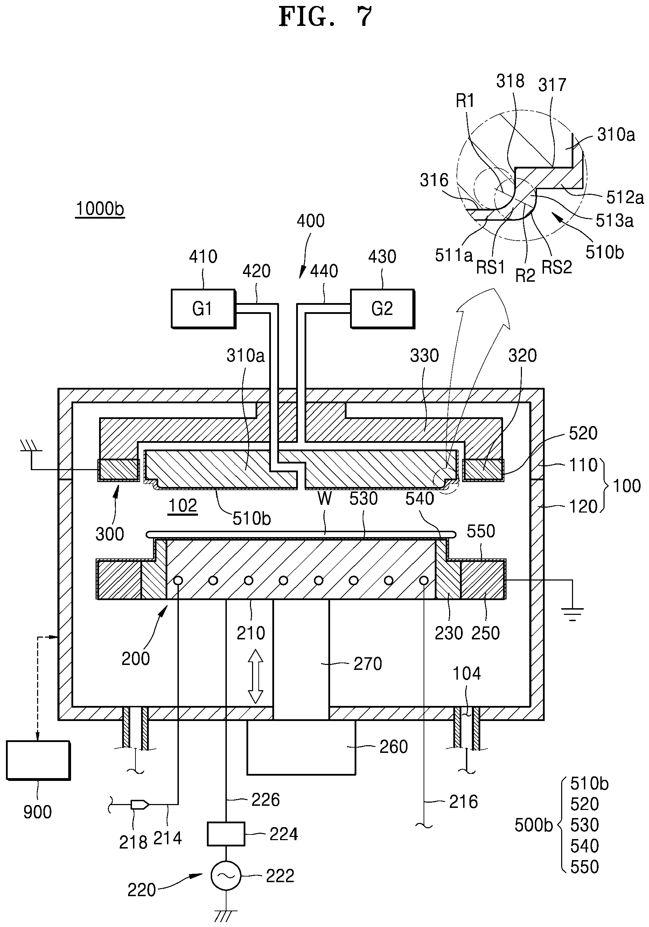

FIG. 7 is a view illustrating a substrate processing apparatus 1000b including a first protective layer 510b having a non-uniform thickness, according to an embodiment. For brevity of description, the description of FIG. 7, which is substantially the same as the description of FIG. 6, is omitted.

The first protective layer 510b included in the substrate processing apparatus 1000b of FIG. 7 may have a non-uniform thickness. A thickness of each of a second sub-protective layer 512a and a third sub-protective layer 513a may be greater than the thickness of the first sub-protective layer 511a. For example, the thickness of each of the second sub-protective layer 512a and the third sub-protective layer 513a may be about 100 µm or more. In addition, the thickness of the first sub-protective layer 511a may be less than about 100 µm. Alternatively, the thickness of each of the second sub-protective layer 512a and the third sub-protective layer 513a may be about 100 µm to about 150 µm, and the thickness of the first sub-protective layer 511a may be about 50 µm to about 100 µm. A thickness of each of second, third, fourth, and fifth protective layers 520, 530, 540, and 550 may be less than or equal to the thickness of the third sub-protective layer 513a and greater than or equal to the thickness of the first sub-protective layer 511a. For example, the thickness of each of the second, third, fourth, and fifth protective layers 520, 530, 540, and 550 may be about 50 µm to about 100 µm.

When the substrate processing apparatus 1000b performs the plasma processing process, the thicknesses of the second sub-protective layer 512a and the third sub-protective layer 513a may decrease relatively faster than the thicknesses of other protective layers, e.g., the first sub-protective layer 511a and the second, third, fourth, and fifth protective layers 520, 530, 540, and 550.

The substrate processing apparatus 1000b according to an embodiment may secure a coating period of a protective layer 500b long by increasing the thicknesses of the second sub-protective layer 512a and the third sub-protective layer 513a having a relatively high plasma contact rate more than other protective layers.

In addition, when the thickness of the protective layer 500b is formed uniformly, the thickness of the protective layer 500b may become non-uniform at a point in time of re-coating, and thus, a remaining protective layer may not be easily removed. The protective layer 500b having a relatively high plasma contact rate, according to an embodiment, may have the great thickness, and thus, the thickness of the remaining protective layer may be relatively uniform at the point in time of re-coating. Thus, the remaining protective layer may be more easily removed.

The third sub-protective layer 513a may be uniform, but is not limited thereto. The thickness of the third sub-protective layer 513a may gradually decrease from the second sub-protective layer 512a to the first sub-protective layer 511a.

As described above, the thickness of the third sub-protective layer 513a may decrease when a plasma processing process is performed. When the thickness of the third sub-protective layer 513a decreases, a second radius of curvature R2 of a second round surface RS2 may also change. For example, the second radius of curvature R2 may increase when the substrate processing apparatus 1000b operates. A change in the second radius of curvature R2 may change a region of a substrate W processed by plasma. For example, the region of the substrate W processed by the plasma may increase when the substrate processing apparatus 1000b operates. Process uniformity of the substrate processing apparatus 1000b may be impaired.

The substrate processing apparatus 1000b according to an embodiment may adjust a gap between the substrate W and the protective layer 500b, e.g., the first sub-protective layer 511a, according to the second radius of curvature R2 to uniformly maintain the processed region of the substrate W. The substrate processing apparatus 1000b according to an embodiment may reduce the gap between the substrate W and the protective layer 500b with an increase in a radius of curvature. In other words, the substrate processing apparatus 1000b may adjust the gap between the substrate W and the protective layer 500b to be inversely proportional to the radius of curvature. The substrate processing apparatus 1000 according to an embodiment may provide an indicator indicating that the protective layer 500 needs to be recoated when the second radius of curvature R2 is too great and thus a defect rate of the substrate W increases or when a deviation of the second radius of curvature R2 is severe and thus the defect rate of the substrate W increases.

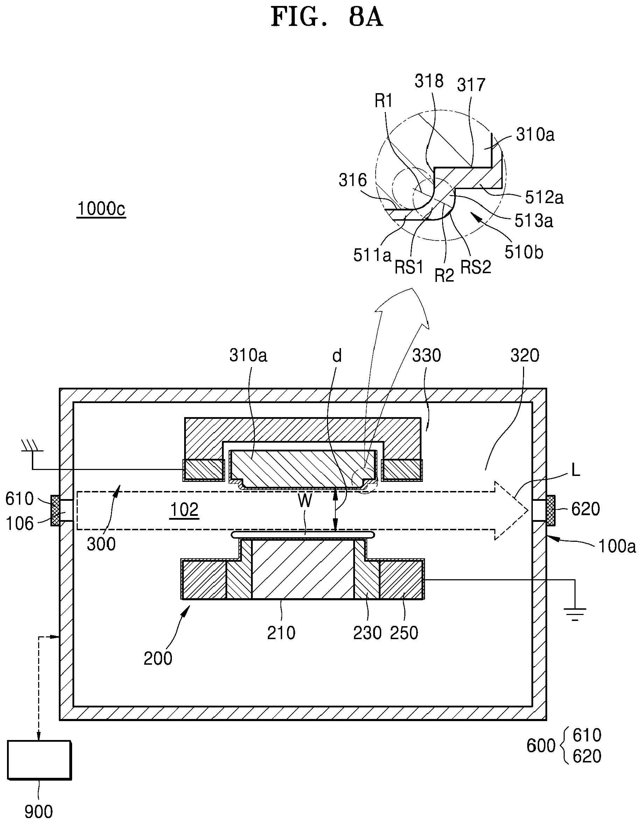

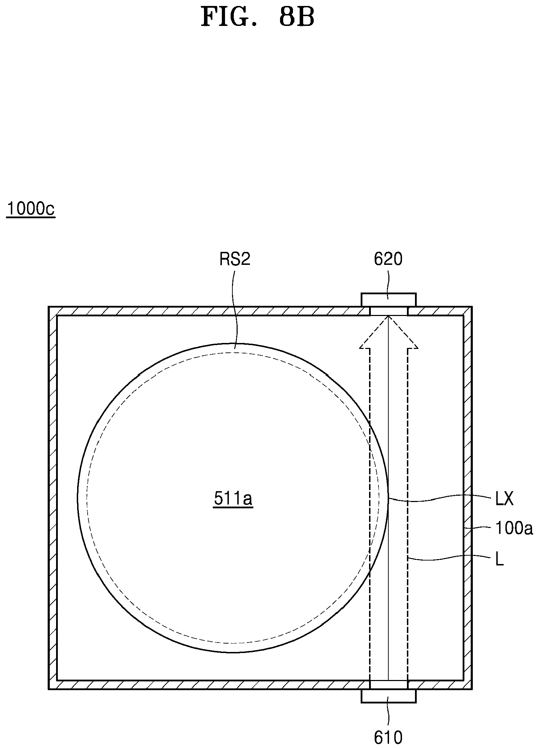

FIG. 8A is view illustrating a substrate processing apparatus 1000c including an optical sensor 600, according to an embodiment, and FIG. 8B is a view schematically illustrating a relationship between a second round surface RS2 and the optical sensor 600. For brevity of description, the description of FIGS. 8A and 8B, which is substantially the same as the description of FIG. 7, is omitted.

Referring to FIGS. 8A and 8B, a housing 100a may include a view port 106. The view port 106 may be a port including a transparent material so that a worker or the like may visually check a processing space 102 of the housing 100a, or the view port 106 may be provided on a sidewall of the housing 100a. A pair of view ports 106 may be provided to face each other.

The view port 106 may be arranged to overlap a third sub-protective layer 513a in a direction parallel to a lower surface of a dielectric plate 310. Alternatively, the view port 106 may be arranged not to overlap an upper surface of a chuck 210 in a direction parallel to the upper surface of the chuck 210. For example, an upper end of the view port 106 may be located higher than the third sub-protective layer 513a, and a lower end of the view port 106 may be located higher than the upper surface of the chuck 210. However, the disclosure is not limited thereto. The lower end of the view port 106 may be located lower than the upper surface of the chuck 210.

The substrate processing apparatus 1000c according to an embodiment may further include the optical sensor 600 capable of acquiring a second radius of curvature R2 of the third sub-protective layer 513a. For example, the optical sensor 600 may acquire the second radius of curvature R of a round surface RS included in the third sub-protective layer 513a by using light. The optical sensor 600 may use light such as an LED or a laser having straightness.

The optical sensor 600 may include a light irradiator 610 and a photodetector 620. The light irradiator 610 and the photodetector 620 may be arranged at the view ports 106 described above. For example, the light irradiator 610 may be installed at one of a pair of view ports 106, and the photodetector 620 may be installed at the other one of the pair of view ports 106. In other words, light L, which is emitted by the light irradiator 610 to the processing space 102 through any one of the pair of view ports 106, may be transmitted to the photodetector 620 through the other one of the pair of view ports 106. The light irradiator 610 and the photodetector 620 may be arranged to face each other with the view ports 106 therebetween.

The light irradiator 610 may irradiate the light L. The photodetector 620 may detect the light L emitted by the light irradiator 610. The photodetector 620 may be arranged on a travel path of the light L irradiated by the light irradiator 610. As shown in FIG. 8B, the second round surface RS2 of the third sub-protective layer 513a may be arranged on the travel path of the light L. For example, a light axis LX included in the travel path of the light L may be parallel to a tangential direction of the second round surface RS2. In addition, the travel path of the light L may overlap the second round surface RS2.

The light irradiator 610 may irradiate the light L toward a first protective layer 510b in the processing space 102. The photodetector 620 may detect light, which travels through the processing space 102 without incident on the first protective layer 510b, from among the light L emitted by the light irradiator 710. For example, a portion of the light L irradiated by the light irradiator 610 may be blocked by the first protective layer 510b, in particular, by the second round surface RS2, and the other portion of the light L may pass through the processing space 102 and then be transmitted to the photodetector 620.

The photodetector 620 may include a processor (not shown) and may acquire the second radius of curvature R2 of the second round surface RS2 by using an amount of light detected, a location at which light is detected, and the like. The second radius of curvature R may be acquired by using a shadow image. However, the disclosure is not limited thereto. A known technique may be applied to the method of acquiring the second radius of curvature R2 by using light, and a detailed description thereof is omitted.

The optical sensor 600 may acquire the second radius of curvature R2, but is not limited thereto. The photodetector 620 may transmit information regarding detected light to the controller 900, and the controller 900 may acquire the second radius of curvature R2. Here, the controller 900 may be the processor of the optical sensor 600.

The optical sensor 600 may be fixed to the housing 100a, but is not limited thereto. The optical sensor 600 may be attached to and detached from the housing 100a. The optical sensor 600 may further include a driver (not shown), and the driver may rotate and move the light irradiator 610 and the photodetector 620 on the housing 100a. In addition, the optical sensor 600 may acquire the second radius of curvature R2 with respect to the second round surface RS2 at various locations. Alternatively, when the optical sensor 600 is fixed on the housing 100a and the housing 100a rotates or a dielectric plate 310 rotates, the optical sensor 600 may acquire the second radius of curvature R2 of the second round surface RS2 at various locations.

The optical sensor 600 may acquire the second radius R2 of curvature of the second round surface RS2 at a particular location and may acquire the second radius of curvature R2 of the second entire round surface RS2. Alternatively, the optical sensor 600 may also acquire a standard deviation of the second radius of curvature R2.

The optical sensor 600 may acquire the second radius of curvature R2, but is not limited thereto. The optical sensor 600 may acquire a gap d between a first sub-protective layer 511a and a substrate W by using the detected light. The gap d between the first sub-protective layer 511a and the substrate W may also be acquired on the basis of an amount of light, a location of the detected light, and the like.

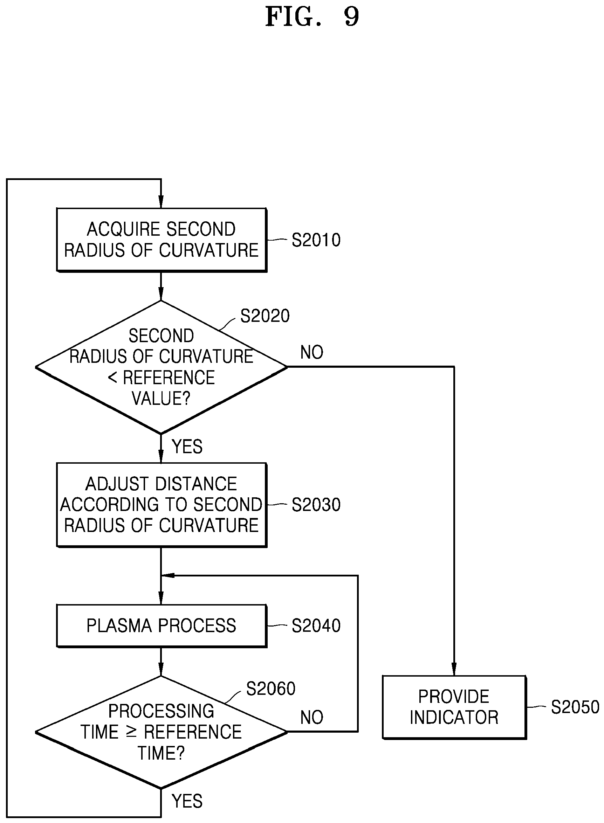

FIG. 9 is a flowchart illustrating a method of adjusting a gap between the first sub-protective layer 511a and the substrate W according to the second radius of curvature R2, according to an embodiment. Referring to FIGS. 8A, 8B, and 9, in operation S2010, the optical sensor 600 may acquire the second radius of curvature R2 with respect to the second round surface RS2. The optical sensor 600 may include the light irradiator 610 and the photodetector 620, and the second round surface RS may be arranged on the travel path of the light L. For example, the light axis LX of the travel path of the light L may be parallel to the tangential direction of the second round surface RS2, and a partial region of the second round surface RS2 may overlap a portion of the travel path of the light L.

The optical sensor 600 may acquire the second radius of curvature R2 on the basis of a location of the detected light and an amount of light. However, the disclosure is not limited thereto. The photodetector 720 may transmit information regarding the detected light to the controller 900, and the controller 900 may acquire the second radius of curvature R2. The second radius of curvature R2 may be a radius of curvature R of a particular location on the second round surface RS2. However, the second radius of curvature R2 is not limited thereto and may also be an average of second radiuses of curvature R acquired at a plurality of locations on the round surface RS. The second radiuses of curvature R2 acquired at the plurality of locations may be acquired when at least one of the optical sensor 600, the housing 100a, and the dielectric plate 310 rotates.

In operation S2020, the controller 900 may determine whether or not the second radius of curvature R2 is less than a reference value. Here, the reference value may be a range in which the substrate W may not be effectively processed even when the gap d between the substrate W and the first sub-protective layer 511a is adjusted, i.e., a range in which the processed substrate W is defective. The reference value may refer to a radius of curvature when the number of substrates W processed as defective is greater than or equal to a certain number. For example, the reference value may be about 10 mm. However, the reference value is not limited thereto and may be adjusted by a designer, a worker, or the like of the substrate processing apparatus 1000.

When the second radius of curvature R2 is less than the reference value in operation S2020, in operation S2030, the controller 900 may adjust the gap d between the substrate W and the first sub-protective layer 511a such that the gap d between the substrate W and the first sub-protective layer 511a 520b is a target gap. The memory 920 of the controller 900 may pre-store, as a lookup table, information regarding the target gap corresponding to the second radius of curvature R2. The second radius of curvature R2 and the target gap may correspond to each other on a one-to-one basis, and the second radius of curvature R2 and the target gap may be inversely proportional to each other. When a plurality of ranges of processed regions of the substrate W are provided, the target gap corresponding to the second radius of curvature R2 may be matched and stored for each range of the processed regions. The controller 900 may read the target gap corresponding to the acquired second radius of curvature R2 from the lookup table stored in the memory 920, and control the actuator 260 such that the gap d between the substrate W and the first sub-protective layer 511a is the target gap.

When the gap d between the substrate W and the first sub-protective layer 511a is adjusted to the target gap, in operation S2040, the substrate processing apparatus 1000 may generate plasma to process the substrate W. For example, the substrate processing apparatus 1000 may process the substrate W by supplying a process gas and generating plasma from the supplied process gas. The substrate processing apparatus 1000 may process an edge region of the substrate W by supplying a process gas and generate plasma from the supplied process gas.

The optical sensor 600 may further measure the gap d between the substrate W and the first sub-protective layer 511a to check whether or not the gap d between the substrate W and the first sub-protective layer 511a is the target gap and apply the result thereof to the controller 900. When a difference between the gap d between the substrate W and the first sub-protective layer 511a and the target gap is within an error range, operation S2040 may be performed. When the difference between the gap d between the substrate W and the first sub-protective layer 511a and the target gap is out of the error range, the controller 900 may readjust the gap d between the substrate W and the first sub-protective layer 511a.

When the second radius of curvature R2 is greater than or equal to the reference value, in operation S2050, the controller 900 may output an indicator indicating that the life of the protective layer 500b expires. The indicator may be output in the form of an image, light, or text through the output unit 940 of the controller 900. When the second radius of curvature R2 is greater than or equal to the reference value, the number of substrates W processed as defective may be greater than or equal to a certain number even when the gap d between the substrate W and the first sub-protective layer 511a is adjusted. The above description may indicate that the life of the protective layer 500b expires. Therefore, the defect rate of the substrate W may be reduced by notifying a worker or the like that the protective layer 500b needs to be recoated or a component coated with the protective layer 500b needs to be replaced.

In operation S2060, the controller 900 may determine whether or not a plasma processing period is greater than or equal to a reference time. The reference time may be a time when a change in the second radius of curvature R2 is expected by plasma processing. The plasma processing may be performed continuously or discontinuously. The plasma processing time may be a sum of times at which the plasma processing is performed.

When the plasma processing time is greater than or equal to the reference time in operation S2060, the substrate processing apparatus 1000c may repeatedly perform the processes of acquiring the second radius of curvature R2 of the second round surface RS2, adjusting the gap d between the substrate W and the first sub-protective layer 511a to correspond to the acquired second radius of curvature R2, and then performing the plasma processing process.

As described with reference to FIG. 9, when the second radius of curvature R2 is greater than or equal to the reference value, the indicator may be provided, but the disclosure is not limited thereto. Even when a standard deviation of the second radius of curvature R2 is greater than or equal to a certain value, the above-described indicator may be provided. Accordingly, when the standard deviation of the second radius of curvature R2 is great, a uniform process capability may not be easily expected.

As described above, the substrate W may be plasma-processed after adjusting the gap d between the substrate W and the first sub-protective layer 511a according to the second radius of curvature R2, and thus, the uniform process capability of the substrate processing apparatus 1000 may be maintained. In addition, even when the second radius of curvature R2 is changed, one protective layer 500b may be used for a long time, and thus, a maintenance cost of the substrate processing apparatus 1000 may be reduced.

The method of adjusting a gap between a substrate and a protective layer according to a radius of curvature of the protective layer has been described on the basis of the substrate processing apparatus 1000c shown in FIGS. 8A and 8B, but is not limited thereto. The method of adjusting the gap between the substrate and the protective layer according to the radius of curvature of the protective layer may also be applied to the substrate processing apparatuses 1000, 1000a, and 1000b including protective layers. In addition, although not shown in the drawings, the method may also be applied to a substrate processing apparatus that performs a plasma processing process while including a protective layer, according to an embodiment.

The method of generating plasma by the substrate processing apparatus 1000 described in the above example may be an inductive coupled plasma (ICP) method. Alternatively, the method of generating plasma by the substrate processing apparatus 1000 described above may be a capacitor couple plasma (CCP) method. Alternatively, the substrate processing apparatus 1000 may generate plasma by using both the ICP method and the CCP method or by using a method selected from the ICP method and the CCP method. Alternatively, the substrate processing apparatus 1000 may generate plasma by using a remote plasma method.

According to an embodiment, a substrate processing apparatus may prevent a component from being damaged by arranging a protective layer having high plasma resistance on the component that is highly likely to collide with plasma within a housing.

According to an embodiment, the use life of the protective layer may increase by increasing a thickness of a region of the protective layer having a high probability of collision with plasma.

According to an embodiment, a uniform process capability for a substrate may be maintained by adjusting a gap between the substrate and the protective layer according to a radius of curvature of the protective layer.

According to an embodiment, the use life of the protective layer may increase by adjusting the gap between the substrate and the protective layer according to the radius of curvature of the protective layer.

According to an embodiment, the uniform process capability for the substrate may be maintained by adjusting the gap between the substrate and the protective layer according to the radius of curvature of the protective layer.

According to an embodiment, a maintenance cost of the substrate processing apparatus may be reduced by adjusting the gap between the substrate and the protective layer according to the radius of curvature of the protective layer.

Effects of the disclosure are not limited to the above-described effects, and effects not mentioned may be clearly understood by one of ordinary skill in the art to which the disclosure pertains from the description and accompanying drawings.

Although a substrate processing apparatus has been described above, the description of the substrate processing apparatus is merely illustrative. It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope of the disclosure as defined by the following claims.

## Claims

1. An apparatus for processing a substrate, the apparatus comprising:
a housing defining a processing space;
a lower electrode unit arranged in the processing space and supporting the substrate;
an upper electrode unit spaced apart from the lower electrode unit with the substrate therebetween;
a gas supply unit configured to supply a process gas for plasma processing an edge region of the substrate; and
a protective layer arranged on a surface of at least a portion of the lower electrode unit and the upper electrode unit and including a material having plasma resistance greater than plasma resistance of each of the lower electrode unit and the upper electrode unit.

2. The apparatus of claim 1, wherein the protective layer comprises a material comprising at least two of Nd, Pm, Sm, Gd, Y, Sc, Er, F, and O.

3. The apparatus of claim 1 or 2, wherein the protective layer comprises at least one of YF₃ and Y₂O₃ as a matrix and comprises at least one of Nd, Pm, Sm, Gd, Sc, and Er as a dopant.

4. The apparatus of any preceding claim, wherein the upper electrode unit comprises a dielectric plate arranged to overlap a portion of the substrate in a thickness direction of the substrate, and the protective layer comprises a first protective layer arranged on a lower surface of the dielectric plate.

5. The apparatus of claim 4, wherein a thickness of the first protective layer is non-uniform.

6. The apparatus of claim 4 or 5, wherein the lower surface of the dielectric plate is stepped.

7. The apparatus of claim 6, wherein the lower surface of the dielectric plate comprises:
a first lower surface spaced apart from the substrate by a first gap;
a second lower surface spaced apart from the substrate by a second gap greater than the first gap; and
a boundary surface connecting the first lower surface to the second lower surface and having a first round surface convex toward the processing space.

8. The apparatus of claim 7, wherein the first protective layer comprises:
a first sub-protective layer arranged on the first lower surface;
a second sub-protective layer arranged on the second lower surface; and
a third sub-protective layer arranged on the boundary surface.

9. The apparatus of claim 8, wherein a thickness of the second sub-protective layer is greater than a thickness of the first sub-protective layer.

10. The apparatus of claim 8 or 9, wherein a thickness of the third sub-protective layer decreases from the second sub-protective layer to the first sub-protective layer.

11. The apparatus of any one of claims 8 to 10, wherein the third sub-protective layer has a second round surface convex toward the processing space.

12. The apparatus of claim 11, wherein a radius of curvature of the second round surface is greater than or equal to a radius of curvature of the first round surface.

13. The apparatus of claim 11 or 12, wherein a gap between the substrate and the first sub-protective layer is adjusted according to the radius of curvature of the second round surface.

14. The apparatus of any one of claims 11 to 13, further comprising an optical sensor arranged on the housing and configured to acquire the radius of curvature of the second round surface by using light.

15. The apparatus of claim 14, wherein the optical sensor comprises:
a light irradiator configured to irradiate the light toward the second round surface; and
a photodetector configured to detect light, from among the light, travelling through the processing space without being blocked by the second round surface.
